Europäisches Patentamt

European Patent Office

Office européen des brevets

(19)

(11) Veröffentlichungsnummer: **0 254 030 B1**

## (12) EUROPÄISCHE PATENTSCHRIFT

(45) Veröffentlichungstag der Patentschrift: **16.12.92**

(51) Int. Cl.⁵: **C25D 17/28**

(21) Anmeldenummer: **87108691.4**

(22) Anmeldetag: **16.06.87**

(54) **Anordnung zur elektrolytischen Behandlung von plattenförmigen Gegenständen.**

(30) Priorität: **19.07.86 DE 3624481**

(43) Veröffentlichungstag der Anmeldung:
**27.01.88 Patentblatt 88/04**

(45) Bekanntmachung des Hinweises auf die
Patenterteilung:
**16.12.92 Patentblatt 92/51**

(84) Benannte Vertragsstaaten:
**BE CH DE ES FR GB IT LI LU NL SE**

(56) Entgegenhaltungen:
**CH-A- 517 633**
**DE-A- 3 236 545**
**US-A- 2 171 437**

(73) Patentinhaber: **SCHERING AKTIENGESELL-
SCHAFT Berlin und Bergkamen
Müllerstrasse 170/178 Postfach 65 03 11
W-1000 Berlin 65(DE)**

(72) Erfinder: **Bläsing, Horst
Strünckweg 1
W-1000 Berlin 13(DE)**
Erfinder: **Kosikowski, Thomas
Stuibenweg 5
W-8500 Nürnberg(DE)**
Erfinder: **Mankut, Ludwig
Memelstrasse 5
W-8503 Altdorf(DE)**
Erfinder: **Meyer, Walter
Klosterheiderweg 18
W-1000 Berlin 28(DE)**

## Beschreibung

Die Erfindung betrifft eine Anordnung gemäß dem Oberbegriff des Anspruches 1. Dabei ist insbesondere an den elektrolytischen Auftrag von Kupfer gedacht. Eine solche Anordnung ist aus der DE-OS 32 36 545 bekannt. Dies hat den Vorteil, daß die plattenförmigen Gegenstände kontinuierlich von der Vorbehandlung her in ihrer waagerechten Lage bleibend durch die Kammer geführt und, ebenfalls in der waagerechten Lage bleibend, der Nachbehandlung zugeführt werden können. Bei dieser vorbekannten Anordnung ist jedoch der Transport der plattenförmigen Gegenstände relativ umständlich und damit nachteilig gelöst. Die plattenförmigen Gegenstände werden dabei an ihren Rändern beidseitig von Rollen oder Rädern erfaßt. Dabei müssen die an einer Seite vorgesehenen Rollen oder Räder in Schlitzführungen gegen Federwirkung gelagert sein. Diese Konstruktion ist äußerst umständlich und aufgrund dieser Kompliziertheit nicht nur teuer, sondern auch im Betrieb störanfällig. Die Stirnkanten der Rollen oder Räder sind mäanderförmig ausgestaltet, um damit der Stromübertragung dienen zu können. Dabei besteht die Gefahr, daß beim Lösen einer Kontaktstelle und noch nicht völligem Anliegen der nächstfolgenden Kontaktstelle der Rollen oder Räder am Plattenrand sich Lichtbogen bilden können. Da die Stirnkanten bzw. Umfangflächen der Rollen oder Räder ständig über die Plattenränder entlang bewegt werden müssen, dürften sie sich relativ kurzzeitig abnutzen. Durch den Elektrolysevorgang wird das auf die plattenförmigen Gegenstände aufzubringende Material auch auf die Rollen oder Räder übertragen. Sie müssen daher zur Entfernung dieses Auftrages immer wieder ausgewechselt, vom Auftrag gesäubert und wieder montiert werden. Dies verlangt nicht nur einen entsprechenden Montage- und damit Kostenaufwand, sondern bedingt auch sehr nachteilige Betriebsunterbrechungen der Anordnung selber. Hinzu kommt der weitere, einen erheblichen konstruktiven Aufwand erfordernde Nachteil, daß jedes Rad bzw. Rolle seinen eigenen Antrieb haben soll.

Ausgehend vom Oberbegriff des Anspruches 1 besteht die Aufgabe der Erfindung zunächst darin, die Transportmittel gegenüber denen des erläuterten Standes der Technik einfacher und robuster zu gestalten, sowie insbesondere ferner im Zusammenhang damit die Überleitung des Stromes auf die plattenförmigen Gegenstände zu verbessern.

Zur Lösung dieser Aufgabe ist, ausgehend vom Oberbegriff des Anspruches 1, zunächst die Merkmalsanordnung gemäß dem Kennzeichen des Anspruches 1 vorgesehen. Die endlos umlaufenden Transportorgane erfassen die Ränder der plattenförmigen Gegenstände - insbesondere ist mit der Erfindung an die elektrolytische Metallisierung von in der Elektronik einzusetzenden elektrischen Leiterplatten gedacht - und bewegen diese durch die Elektrolysekammer. Dabei ist - abgesehen vom Beginn des Ergreifens bzw. Beginn des Freigebens - keine Relativbewegung zwischen den Transportorganen und den Plattenrändern gegeben. Abnützungs- bzw. Abriebserscheinungen der Transportorgane sind daher vermieden. Nach Durchlaufen des Transportweges innerhalb der Elektrolysekammer werden die Transportorgane selbsttätig vom Plattenrand gelöst und außerhalb der Elektrolysekammer wieder zurückgeführt, bis sie zum Beginn des Transportweges selbsttätig wieder zum Erfassen des Randes eines der plattenförmigen Gegenstände kommen. Dies erleichtert und vereinfacht auch den Antrieb der Transportorgane. Es muß nicht jedes einzelne Transportorgan für sich angetrieben werden, sondern es genügt gemäß einer bevorzugten Ausführungsform der Erfindung (siehe Anspruch 5) ein endlos umlaufendes Transportband, an dem alle Transportorgane angebracht sind, wobei nur das Transportband angetrieben werden muß. Es ist eine einfache und robuste Ausgestaltung der Transportorgane möglich.

Eine in ihrer Gestaltung und Funktion besonders einfache und zugleich vorteilhafte Ausführung der Erfindung ist Gegenstand des Anspruches 3. Diese Bügel haben eine starke Klemmwirkung, wobei aber durch die Anlaufschiene die Bügel in einfacher und zugleich sicherer Weise zum klemmenden Erfassen der plattenförmigen Gegenstände bzw. deren Freigabe gebracht werden können.

Zur Lösung der vorstehend, insbesondere angegebenen Aufgabenstellung der Verbesserung der Überleitung des Stromes auf die plattenförmigen Gegenstände dienen die Merkmale des Anspruches 7. Dies ist durch die erfindungsgemäßen Transportorgane erreichbar.

Zur Vermeidung der zum Stand der Technik geschilderten Nachteile nützen die Merkmale des Anspruches 9 den Umlauf der Transport- und Stromübertragungsorgane mit Hilfe eines endlosen Bandes aus, um während der Bewegung der Transport- und Stromübertragungsorgane außerhalb des Transportweges der plattenförmigen Gegenstände, d.h. außerhalb der Elektrolysekammer, für eine Entmetallisierung von während der Elektrolyse aufgetragenen Metall, hier bevorzugt Kupfer, zu sorgen.

Weitere Vorteile und Merkmale der Erfindung sind den weiteren Unteransprüchen, sowie der nachstehenden Beschreibung und der zugehörigen Zeichnung von erfindungsgemäßen Ausführungsmöglichkeiten zu entnehmen. In der Zeichnung zeigt:

Fig. 1:   Eine im wesentlichen schematische Draufsicht auf eine Anordnung nach der Erfindung,

Fig. 2: eine gegenüber Fig. 1 etwas abgewandelte Ausführungsform der Erfindung, entsprechend einem Schnitt gemäß der Linie II - II in Fig. 1.

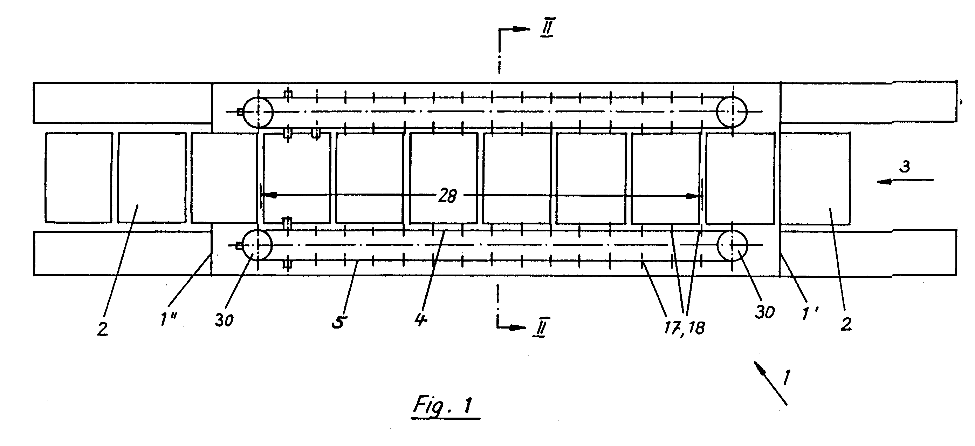

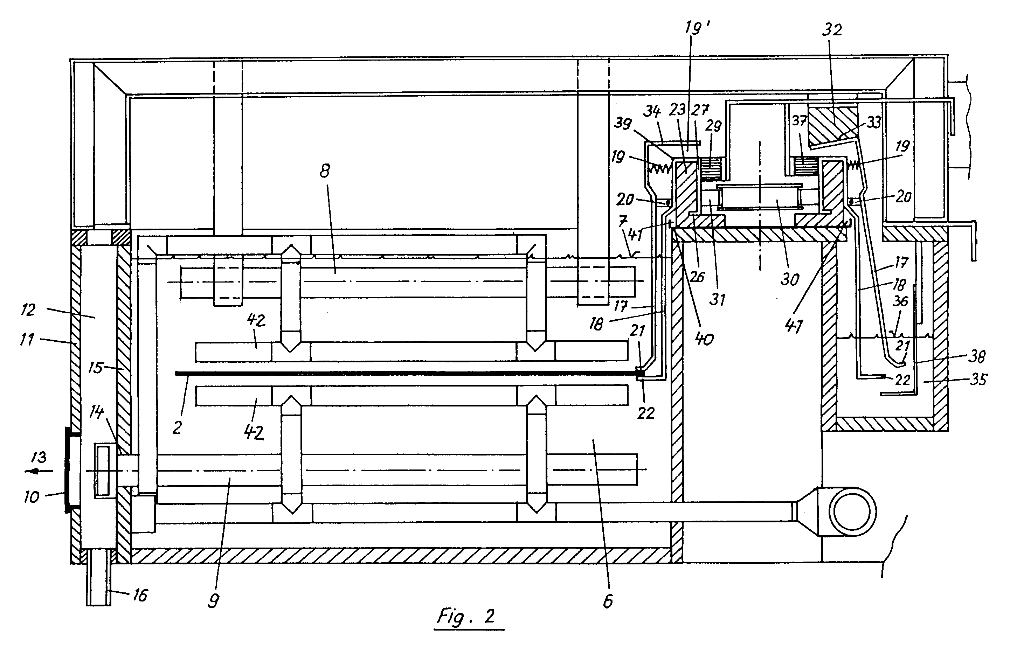

Fig. 1 zeigt schematisch und in einem gegenüber Fig. 2 verkleinerten Maßstab eine Draufsicht auf eine Elektrolysekammer 1, der die plattenförmigen Gegenstände 2 in Richtung des Pfeiles 3 durch hier nicht gezeichnete Transportmittel zugeführt werden, bevorzugt von einer oder mehreren Vorbehandlungsstationen her, die ebenfalls in der Zeichnung nicht dargestellt sind. Die plattenförmigen Gegenstände 2 treten damit in der Transportrichtung 3 an der Seite 1' der Elektrolysekammer 1 ein, durchlaufen diese und treten dann an der der Seite 1' gegenüberliegenden Seite 1'' wieder aus.

Fig. 2 zeigt das Elektrolysebad 6 innerhalb der Kammer 1. Die Badoberfläche 7 ist oberhalb von oberen Anoden 8 gelegen, die sich oberhalb der plattenförmigen Gegenstände 2 bzw. deren Transportweg befinden. Darunter sind untere Anoden 9 angeordnet. Die Anoden 8, 9 können Platten aus dem aufzutragenden Metall, bevorzugt Kupfer, sein. Es können aber auch dafür Behälter aus einem von der Elektrolyse nicht abtragbaren Material (z.B. Titan)vorgesehen sein, welche das jeweilige aufzutragende Metall beinhalten. Die oberen Anoden 8 können zum Auswechseln nach oben abgehoben bzw. von oben her eingesetzt werden. Die unteren Anoden 9 können nach Entnahme eines Abdichtdekels 10 nach Abschalten der Einrichtung und nachdem das Elektrolytvolumen aus der Kammer in einen Sammelbehälter abgeflossen ist, aus dem die Pumpe bzw. Pumpen bei wieder Inbetriebnahme den Elektrolyt wieder fördern, in der linken Seitenwand 11 einer Nebenkammer 12 in Pfeilrichtung 13 herausgezogen werden. Sie durchsetzen dabei eine Bohrung 14 in der Kammerwandung 15. Daraus austretende Elektrolytflüssigkeit wird in der Nebenkammer 12 gesammelt und durch deren Abflußrohr 16 einer Pumpe und von dieser wieder in das Behälterinnere zum Elektrolysebad 6 zurückgeführt.

Die Stromzuführungen zu den beim Betrieb stationären Anoden 8, 9 sind in der Zeichnung nicht gesondert dargestellt. Die Stromzuführung zu den im Betrieb beweglichen, die Kathode bildenden plattenförmigen Gegenständen erfolgt gemäß einer bevorzugten, nachstehend beschriebenen und in der Zeichnung dargestellten Ausführungsform der Erfindung über die Transportmittel. Eine bevorzugte Ausführungsform dieser Transportmittel wird nachstehend erläutert:

Die Transportmittel sind Klammern, die in diesem Beispiel aus zwei Bügeln 17, 18 bestehen, die durch den Druck einer Feder 19 um ihren gegenseitigen und Strom leitenden Verbindungs- bzw. Anlegepunkt 20 so verschwenkt werden, daß ihre in Fig.2 unteren Enden 21, 22 durch den Federdruck gegeneinandergepreßt werden und dabei den Seitenrand des jeweiligen plattenförmigen Gegenstandes 2, hier einer Leiterplatte für elektronische Zwecke, erfassen. Der Bügel 18 umgreift eine Führungsschiene 23 und ist mit seinem Ende 26 so in dieser geführt, daß er entlang der Schiene gleitet. Der Teil 27 des Bügels 18 gleitet entlang einer Bürstenanordnung 29, die sich über den Transportbereich 28 (siehe Fig. 1) erstreckt und während dieses Transportes allen Bügeln 18, welche die plattenförmigen Gegenstände 2 erfassen, den Strom mit der zutreffenden Polarität zuführen.

Fig. 1 zeigt ferner, wie eine größere Anzahl von Klammern bzw. Bügeln 17, 18 hintereinander und im Abstand voneinander an einem endlosen über die Rollen 30 umlaufenden Band 31 angebracht sind. Das Antriebsband 31 kann ein Kunststoffzahnriemen oder eine Kunststoffkette sein, wobei die Rollen 30 eine dazu passende Zahnung aufweisen. Die Führungsschiene 23 läuft vollständig um, während eine Anlaufschiene 32 mit einer Anlauffläche 33 sich nur über den Nicht-Transportbereich der Klammern erstreckt, also von den Enden des Transportbereiches 28 her um die beiden Antriebsrollen 30 und entlang des in Fig. 1 dargestellten äußeren Trums 5 des Transportbandes. Dagegen entspricht das jeweils innere Trum 4 des Antriebsbandes 31 in etwa dem Transportbereich 28. Die Anlauffläche 33 ist zu einem abgewinkelten Endteil 34 des Bügels 17 so positioniert, daß sie ihn unter Zusammendrücken der Feder 19 in die in Fig. 2 rechts dargestellte Lage verschwenkt, in der die Enden 21, 22 der Bügel 17, 18 voneinander entfernt sind, d.h. keine Klemmwirkung auf den plattenförmigen Gegenstand mehr ausüben können. Somit werden die plattenförmigen Gegenstände von den Klammern bzw. den Bügeln 17,18 nach ihrem Eintritt in die Elektrolysekammer erfaßt und vor ihrem Austritt wieder freigegeben. Zugleich wird während dieses Durchganges über den Bügel 18 der Strom, wie erläutert, den plattenförmigen Gegenständen zugeführt. Der Antrieb der Führungsrollen 30 ist nicht gesondert dargestellt. Die Federn 19 stützen sich jeweils zwischen den in Fig. 2 oberhalb des Anlenkpunktes 20 befindlichen Bügelarmen 34 und 39 ab. Dies ist eine konstruktiv einfache und zugleich zwecks Erzeugung der Klemmkraft zwischen den Bügelenden 21, 22 vorteilhafte Anordnung. Man könnte die beiden Bügel auch so anordnen, daß sie nicht um den Punkt 20 gegeneinander schwenkbar sind, sondern daß die Gelenkverbindung 20 entfällt, der Bügel 17 relativ zum Bügel 18 senkrecht verschiebbar ist und sich eine die Andruckkraft bewirkende Zugfeder (im einzelnen nicht dargestellt) an der mit 19' bezeichneten Stelle befindet. Die Zugfeder drückt dann die Bügelenden 21,22 zusammen. Das Auseinanderbewegen der Bügelenden beim Verlassen des Transportbereiches wird durch eine ebenfalls nicht dargestellte entsprechend gestaltete Anlauffläche bewirkt. Fig. 2 zeigt ferner, daß die Transporteinrichtungen bevorzugt so gestaltet und angeordnet sind, daß sich alle Bauelemente, an denen Gleitbewegungen und damit ein Abrieb auftreten können, seitlich der Elektrolysebehälter befinden. Damit wird verhindert, daß Abriebspartikel in das Bad fallen und zu Fehlerstellen im durch die Elektrolyse abgeschiedenen Metall führen. Ein solcher Abrieb kann zwischen den Bügelarmen 39 und der Führungsschiene 23 entstehen. Um ihn aufzufangen ist ein Fangblech 40 vorgesehen, das oberhalb des Flüssigkeitsspiegels 7 des Bades 6 und der nachstehend zu erläuternden Entmetallisierungskammer 35 eine Auffangrinne 41 für einen solchen Abrieb bildet.

Während des Elektrolysevorganges innerhalb des Bades 6 schlägt sich das jeweilige Metall auch auf den Bügeln 17, 18 nieder. Es empfiehlt sich daher, diese oberhalb ihrer Enden 21, 22 bis nach oben über den Flüssigkeitsspiegel 7 hinaus mit einer dies verhindernden Kunststoffumhüllung (nicht dargestellt) zu versehen. Um nun das sich an den Enden 21, 22 niederschlagende Metall wieder zu entfernen ist eine weitere Badkammer (Entmetallisierungskammer) 35 vorgesehen, die ebenfalls von der Elektrolyseflüssigkeit gefüllt ist (sie kann einen gegenüber dem Spiegel 7 niedrigeren Spiegel 36 haben). Sobald sich die Bügel 17, 18 in diesem Bad 35 befinden wird ihnen über eine weitere Bürstenanordnung 37 ein Strom von einer Polarität zugeführt, welche entgegengesetzt zu der Polarität der Stromzuführung durch die Bürstenanordnung 29 ist. Beide Bürstenanordnungen erstrekken sich im übrigen über die gesamte Länge beider Trums 4,5 des Antriebsriemens 31. Der Gegenpol wird von einem Teil 38 gebildet, das in das Bad 35 hineinragt. Damit wird an den Enden 21, 22 niedergeschlagenes Metall beim Durchgang der Bügel durch das Bad 35 auf elektrolytischem Wege wieder entfernt. Gegebenenfalls wäre auch eine Entmetallisierung auf chemischen Wege möglich.

Fig. 1 zeigt, daß die vorstehend erläuterten Transport- und Stromzuführungsmittel links und rechts der Elektrolysekammer 1 vorgesehen sein können, d.h. die hindurchgeführten plattenförmigen Gegenstände beidseitig erfassen. Dies ist dann erforderlich, wenn sehr dünne Platten (Folien) behandelt werden wollen. Fig. 2 zeigt dagegen, daß diese Transport- und Stromzuführungsmittel auch nur an einer Seite der plattenförmigen Gegenstände vorgesehen sein können. Mit 42 sind Zulaufrohre für die Elektrolyseflüssigkeit beziffert.

Alle dargestellten und beschriebenen Merkmale, sowie ihre Kombinationen untereinander, sind erfindungswesentlich.

**Patentansprüche**

1. Anordnung zum elektrolytischen Auftrag eines Metalles auf plattenförmige Gegenstände, wie Leiterplatten, bei der diese Gegenstände für eine gewisse Verweildauer in ein Elektrolysebad gebracht und dann wieder aus dem Bad entfernt werden, wobei die plattenförmigen Gegenstände in waagerechter Lage einer die Anordnung bildenden Elektrolysekammer zugeführt, durch diese kontinuierlich hindurchgeleitet und nach der Elektrolysebehandlung aus der Kammer wieder herausgeführt werden und wobei Anoden, Stromzuführungen und Transportmittel vorgesehen sind, dadurch gekennzeichnet, daß die Transportmittel aus einer endlos umlaufenden, angetriebenen Reihe einzelner, in Form von Klammern ausgebildeter Transportorgane bestehen, welche in der über den Transportbereich (28) sich erstreckenden Transportstellung, die Ränder der plattenförmigen Gegenstände umklemmend ergreifen und in der Transportrichtung (3) bewegen, wobei die Klammern aus zwei Bügeln bestehen, die unter Federdruck in die Klemmstellung gebracht werden und damit die Klemmkraft ausüben und daß am Beginn und am Ende des in der Elektrolysekammer (1) gelegenen Transportweges (28) der plattenförmigen Gegenstände (2) Mittel zum Öffnen der Klammern gegen den Federdruck vorhanden sind, damit die plattenförmigen Gegenstände erfaßt und auch wieder freigegeben werden können und daß die Transportorgane zugleich der Stromzuführung zu den plattenförmigen Gegenständen (2) dienen.

2. Anordnung nach Anspruch 1, dadurch gekennzeichnet, daß eine Anlauffläche (33) einer Anlaufschiene (32) vorgesehen ist, die sich über den Nicht-Transportbereich des Transportorgan-Umlaufes erstreckend durch Angriff an einen oder beide der Bügel und diese in die Freigabestellung bringt.

3. Anordnung nach Anspruch 1 oder 2, dadurch gekennzeichnet, daß die Klammern bzw. die Bügel (17, 18) an einer endlos umlaufenden Führungsschiene (23) geführt werden.

4. Anordnung nach einem der Ansprüche 1 - 3, dadurch gekennzeichnet, daß die Transportorgane, insbesondere in Form der Bügel (17, 18), an einem endlosen umlaufenden Transportband (31) im Abstand voneinander angebracht sind.

**5.** Anordnung nach einem der Ansprüche 1 - 4, dadurch gekenngekennzeichnet, daß pro Bügel (17, 18) eine Druckfeder (19) vorgesehen ist, die sich oberhalb der Anlenkverbindung (20) beider Bügel (17, 18) befindet und zwischen den oberen Bügelarmen (34, 39) abstützt.

**6.** Anordnung nach Anspruch 1, dadurch gekennzeichnet, daß eine stationäre Bürstenordnung (29) vorgesehen und an den Klammern bzw. Bügeln anliegt.

**7.** Anordnung nach einem der Ansprüche 1 - 6, dadurch gekennzeichnet, daß für die Transportorgane, insbesondere in Form der Bügel (17, 18), außerhalb des Transportbereiches (28) eine mit der Elektrolyseflüssigkeit gefüllte weitere Badkammer (Entmetallisierungskammer) (35) vorgesehen ist und daß die Transportorgane (17, 18) dort ebenfalls über eine stationäre Bürstenanordnung (37) oder dergleichen eine Stromzuführung erhalten, wobei jedoch die Stromrichtung eine umgekehrte Polarität als die Stromzuführung für die im Transportbereich befindlichen Transportorgane hat.

**8.** Anordnung nach Anspruch 7, dadurch gekennzeichnet, daß die Entmetallisierungskammer (35) die Funktion einer Nebenkammer für die Aufnahme von Elektrolytflüssigkeit hat, welche beim Übergang von der bzw. zu der Elektrolysekammer (1) an den Durchgangsstellen der Klammern bzw. Bügel austritt.

**9.** Anordnung nach einem der Ansprüche 1 - 8, dadurch gekennzeichnet, daß Stromzuführung und/oder Transport der plattenförmigen Gegenstände an einer oder an beiden Längsseiten des Transportweges der plattenförmigen Gegenstände vorgesehen sind.

**10.** Anordnung nach einem der Ansprüche 1 - 9, dadurch gekennzeichnet, daß Teile der Anordnung, an denen bei Bewegung der Transportorgane ein Abrieb entstehen kann, sich seitlich außerhalb von Elektrolyseflüssigkeit aufweisenden Kammern (6, 35) befinden.

**Claims**

**1.** A device for electrolytic deposition of a metal onto plate-shaped objects, comprising an electroplating bath filled with electrolytic liquid and admitting said objects for a certain period of time, said bath having an electroplating chamber to which the objects are continually fed in a horizontal position and from which they are discharged after an electrolytic treatment; anodes positioned in said chamber; means for applying current to said objects which serve as cathodes; and means for transporting said objects, said transporting means including at least one endless rotating belt and a plurality of transporting elements positioned on said belt and driven thereby in an endless row one after another, said transporting elements firmly holding side edges of the plate-shaped objects and moving in a transport direction over a transport path which is defined at a beginning and at an end of said chamber; and means effecting an engagement of said plate-shaped objects by said transporting elements and a release of said objects from said transporting elements.

**2.** The device as defined in claim 1, wherein said transporting elements are clamps which releasably engage the edges of said objects over said transport path in said chamber.

**3.** The device as defined in claim 2, wherein each clamp includes two yokes biased by springs supported therebetween, said springs exerting on said yokes a clamping force to place them in a clamping position in which they seize an edge of an object being treated, said effecting means including a rail having an onset surface which acts on at least one of said yokes so as to bring said one yoke in a non-transporting region to a release position.

**4.** The device as defined in claim 3, wherein a guiderail is provided for guiding said yokes, said guide rail being endless and rotatable.

**5.** The devices as defined in claim 4, said yokes being positioned in pairs on said belt at intervals from each other.

**6.** The device as defined in claim 5, wherein a compression spring is provided for each yoke, each yoke being pivotable about a pivot connection and having an arm overlapping a respective spring which is positioned above a respective pivot connection and below said arm.

**7.** The device as defined in claim 6, wherein said current applying means are provided on said transport elements.

**8.** The device as defined in claim 7, wherein said current applying means includes a stationary wiper arrangement which lies on said yokes in the region of said transport path.

9. The device as defined in claim 8, further including an additional bath chamber filled with electrolytic liquid and positioned outside said transport path, and an additional stationary wiper arrangement applied to said yokes so as a current applied to said yokes is of a polarity opposite to that of the yokes positioned in said transport path and applied by said wiper arrangement which lies on said yokes in the region of said transport path so as to demetallize the ends of said yokes.

10. The device as defined in claim 9, wherein said additional bath is filled with the electrolytic liquid which upon the transfer from or to said electroplating bath is applied to passing locations of said yokes to demetallize them.

**Revendications**

1. Système pour la déposition électrolytique d'un métal sur des objets en forme de cartes tels que des cartes imprimées, dans lequel ces objets sont placés pour une certaine durée de séjour dans un bain à l'électrolyse puis de nouveau retirés du bain, les objets en forme de cartes étant amenés, en position horizontale, à une chambre électrolytique formant le système, étant conduits en continu dans cette dernière puis sortis de la chambre après le traitement électrolytique, et des anodes, des câbles d'alimentation du courant et des moyens de transport étant également prévus, ledit système étant caractérisé en ce que les moyens de transport sont constitués d'une série de différents organes de transport entraînés et en rotation continue, configurés sous forme de crampons, ces organes saisissant - en les serrant tout autour les bords - les objets en forme de cartes dans leur position de transport, maintenue pendant tout le trajet de transport (28), et les déplaçant dans la direction du transport (3), les crampons étant constitués de deux étriers amenés en position de serrage par pression de ressort, exerçant ainsi la force de serrage, et en ce que des dispositifs permettant d'ouvrir les crampons contre la pression de ressort existent au début et à la fin d'un secteur du trajet de transport (28) des objets en forme de cartes (2) situé dans la chambre électrolytique (1) afin que les objets en forme de cartes (2) puissent être saisis puis libérés de nouveau, et en ce que les organes de transport servent en même temps d'amenée du courant aux objets en forme de cartes (2).

2. Système selon la revendication 1, caractérisé en ce qu'une surface-rampe (33) sur une glissière d'entrée (32) est prévue, cette surface-rampe s'étendant sur le secteur de non-transport du trajet des organes de transport et exerçant une action sur l'un ou les deux étriers pour les amener en position de relâchement.

3. Système selon la revendication 1 ou 2, caractérisé en ce que les crampons ou étriers (17,18) sont guidés dans une glissière en rotation continue (23).

4. Système selon l'une des revendications 1 - 3, caractérisé en ce que les organes de transport, et en particulier les étriers (17,18), sont montés, espacés les uns des autres, sur une bande transporteuse sans fin à rotation continue (31).

5. Système selon l'une des revendications 1 - 4, caractérisé en ce qu'un ressort de pression (19) par étrier (17,18) est prévu, ce ressort se trouvant au-dessus de la jonction articulée (20) des deux étriers (17,18) et s'appuyant entre les branches supérieures des étriers (34,39).

6. Système selon la revendication 1, caractérisée en ce qu'une suite de brosses fixes (29) est prévue, et placée contre les crampons ou étriers.

7. Système selon l'une des revendications 1 - 6, caractérisé en ce que pour les organes de transport, et en particulier les étriers (17,18), une chambre de bain supplémentaire remplie du liquide d'électrolyse (chambre de démétallisation) (35) est prévue en-dehors du secteur de transport (28) et qu'un courant d'alimentation est amené aux organes de transport (17,18) à cet endroit, également par une suite de brosses fixes (37) ou un dispositif similaire, la direction de ce courant ayant toutefois une polarité inverse par rapport à l'amenée de courant pour les organes de transport se trouvant dans le secteur de transport.

8. Système selon la revendication 7, caractérisé en ce que la chambre de démétallisation (35) a une fonction de chambre auxiliaire pour la réception du liquide d'électrolyse qui déborde lors du passage en provenance ou vers la chambre électrolytique (1) aux endroits de traversée des crampons ou étriers.

9. Système selon l'une des revendications 1 - 8, caractérisé en ce que l'amenée du courant et/ou le transport des objets en forme de cartes est prévu sur l'un ou sur les deux grands côtés du trajet de transport des objets en forme de cartes.

10. Système selon l'une des revendications 1 - 9, caractérisé en ce que les parties du système sur lesquelles une usure par frottement peut apparaître en raison du déplacement des organes de transport sont installées latéralement en-dehors des chambres présentant du liquide d'électrolyse (6,35).

Fig. 1

Fig. 2

EP 0 254 030 B1